Europäisches Patentamt

European Patent Office

Office européen des brevets

(19)

(11) Veröffentlichungsnummer : **0 071 823**
**B1**

(12) **EUROPÄISCHE PATENTSCHRIFT**

(45) Veröffentlichungstag der Patentschrift :
07.05.86

(51) Int. Cl.⁴ : **G 03 F   7/26**

(21) Anmeldenummer : **82106566.1**

(22) Anmeldetag : **21.07.82**

(54) **Entwicklerlösing für positiv-arbeitende strahlungsempfindliche Reproduktionsschichten.**

(30) Priorität : **06.08.81 US 290634**

(43) Veröffentlichungstag der Anmeldung :
**16.02.83 Patentblatt 83/07**

(45) Bekanntmachung des Hinweises auf die Patenterteilung : **07.05.86 Patentblatt 86/19**

(84) Benannte Vertragsstaaten :
**AT CH DE LI**

(56) Entgegenhaltungen :
**DE-A- 2 828 891**
**DE-A- 2 846 256**
**GB-A- 1 591 988**
**US-A- 3 615 480**
**US-A- 4 049 453**
**US-A- 4 147 545**

(73) Patentinhaber : **AMERICAN HOECHST CORPORATION**
**Route 202-206 North**
**Somerville, N.J. 08876 (US)**

(72) Erfinder : **Shane, Hsieh**
**4, Linvale Lane**
**Bridgewater New Jersey 08807 (US)**

(74) Vertreter : **Euler, Kurt Emil, Dr. et al**
**KALLE Niederlassung der Hoechst AG Rheingaustrasse 190 Postfach 3540**
**D-6200 Wiesbaden 1 (DE)**

## Beschreibung

Die vorliegende Erfindung betrifft Entwicklerlösungen für positiv-arbeitende Reproduktionsschichten, insbesondere Entwicklerlösungen zum Ablösen der Nichtbildstellen auf belichteten, positiv-arbeitenden Offsetdruckplatten.

In der Vergangenheit sind verschiedene Verfahren für das Entwickeln von Druckplatten angewendet worden. Bei einem dieser Verfahren werden die Nichtbildstellen der Platte mit Lösemitteln, wie z. B. Isopropylalkohol, Butylalkohol, Benzylalkohol und Ethylenglykolmonoethylether, entfernt. Die Verwendung solcher Lösemittel ist unvorteilhaft, weil sie verhältnismäßig teuer sind und beim Entwicklungsvorgang dazu neigen, zusammen mit den Nichtbildstellen auch etwas vom Bild wegzulösen.

Bei anderen Verfahren werden ätzende anorganische Verbindungen verwendet, wie z. B. Trinatriumphosphat, Natrium-hydroxid oder Natriummetasilikat. Das Arbeiten mit diesen Verbindungen kan jedoch gefährlich sein, und sie neigen dazu, den Träger, auf dem die strahlungsempfindliche Beschichtung aufgetragen ist, anzugreifen. Das gilt insbesondere für Aluminium und/oder Aluminiumoxid, die bei den meisten Offsetdruckplatten als Träger dienen.

Die US-PSen 3 891 439 und 4 147 545 (= DE-OS 2 353 992) verwenden als Entwickler wäßrige Lösungen organischer Lithiumsalze, wie z. B. Lithiumbenzoat. Diese haben jedoch den Nachteil einer verhältnismäßig langen Entwicklungszeit und sollen nur bei negativ-arbeitenden Druckplatten wirksam sein.

Die DE-A 28 46 256 beschreibt einen wäßrigen Alkalisilikat-Entwickler für Positivplatten mit einem $SiO_2$/Alkalimetall-Verhältnis von 0,5 bis 0,75, wobei die $SiO_2$-Konzentration 1 bis 4 Gew.-% betragen soll. Es werden Lithium-, Natrium- oder Kaliumsilikate beschrieben, wobei der Einsatz von Natrium- oder Kaliumsilikaten bevorzugt ist.

Die obengenannten bekannten Entwickler haben mehrere Nachteile. Wenn zum Beispiel die Natriummetasilikat- oder Trinatriumphosphatlösung mit Natriumhydroxid auf einen pH-Wert von etwa 13 eingestellt wird, um eine hohe Entwicklungsgeschwindigkeit zu erreichen, wird der Entwickler äußerst aggressiv gegenüber der Oxidschicht auf dem Aluminiumträger. Wird dagegen der Natriumhydroxidanteil verringert, um den Angriff auf die Oxidschicht des Aluminiumträgers auf ein Mindestmaß zu beschränken, wird die Entwicklungsgeschwindigkeit für praktische Anwendungen zu langsam. Darüber hinaus sind die Reaktionsprodukte der alkalischen Entwicklerbestandteile mit dem Aluminiumträger, z. B. in Form von Aluminiumsilikat, im Entwickler weitgehend unlöslich. Die ausgefällten Produkte in der Entwicklerlösung wirken sich bei Verwendung des Entwicklers in Entwicklungsmaschinen nachteilig aus, da sie den Entwicklungsvorgang stören und Maschinenschäden verursachen können.

Aus der US-A 3 615 480 ist ein Entwickler für die Herstellung von Reliefbildern in photopolymerisierbaren Schichten bekannt, der aus Wasser und wenigstens einem damit mischbaren, speziellen organischen Lösemittel besteht, z. B. bestimmten Alkoholen, Ketonen oder Ether, und der als Zusatz lösliche Lithium-, Natrium- oder Kaliumsilikate enthält, die ein $SiO_2$/Alkalimetalloxid-Verhältnis von über 1,5 : 1 haben sollen. Als Zusätze können auch Mischungen von Natrium- und Lithiumsilikaten im Verhältnis 1 : 1 eingesetzt werden, wobei der pH-Wert zwischen 10 und 13 liegt.

Neben den genannten Mängeln besteht der Nachteil eines solchen Entwicklers u. a. darin, daß er ein organisches Lösemittel enthält, wodurch sich Umweltbelastungen ergeben. Außerdem ist der Entwickler auf spezielle photopolymerisierbare Schichten abgestimmt.

Es ist daher Aufgabe der Erfindung, einen verbesserten Entwickler für Offsetdruckplatten zu schaffen, der eine sehr hohe Entwicklungsgeschwindigkeit erreicht und dabei die Oxidschicht des Aluminiumträgers im wesentlichen nicht angreift und bei dem keine unlöslichen Ausfällungen entstehen, die die Entwicklung behindern oder die Entwicklungsmaschinen beschädigen.

Gegenstand der Erfindung ist eine wäßrig-alkalische Entwicklerlösung für belichtete, positiv-arbeitende strahlungsempfindliche Reproduktionsschichten mit einem Gehalt an Lithiumverbindungen, deren kennzeichnendes Merkmal darin besteht, daß sie 0,1 bis 10 Gew.-% mindestens einer anorganische Lithiumverbindung aus der Gruppe Lithiumhydroxid, -chlorid, -bromid, -nitrat, -carbonat und -sulfat und 1 bis 20 Gew.-% Natriummetasilikat enthält. Es hat sich gezeigt, daß mit diesem Gemisch eine hohe Entwicklungsgeschwindigkeit erreicht wird, der Angriff auf den Träger sich erheblich reduziert und die bildformenden Stellen der strahlungsempfindlichen Beschichtung dem Ablösen durch den Entwickler innerhalb einer für die Praxis brauchbaren Entwicklungszeit standhalten können. Das Gemisch eignet sich besonders für das Entwickeln von Druckplatten oder Fotoresists.

Ein weiterer Gegenstand der Erfindung ist ein Verfahren zum Entwickeln von belichteten, positiv-arbeitenden strahlungsempfindlichen Reproduktionsschichten mit einer wäßrig-alkalischen Entwicklerlösung eines Gehalts an Lithiumverbindungen, dessen kennzeichnendes Merkmal darin besteht, daß eine Lösung mit einem Gehalt von 0,1 bis 10 Gew.-% an mindestens einer anorganische Lithiumverbindung aus der Gruppe Lithiumhydroxid, -chlorid, -bromid, -nitrat, -carbonat und -sulfat und von 1 bis 20 Gew.-% an Natriummetasilikat eingesetzt wird.

Bei der Herstellung von positiv-arbeitenden Druckplatten und Fotoresists werden als strahlungsempfindliche Verbindungen weitgehend o-Naphthochinondiazide verwendet (wie in den US-PSen 3 046 110 bis 3 046 119, 3 046 121, 3 046 124, 3 106 465, 3 148 983, 3 180 733 und 3 188 210 beschrieben). Diese o-

Naphthochinondiazide sind im allgemeinen in bestimmten organischen Lösemitteln löslich ; in Wasser, schwachen Säuren und schwachen alkalischen Lösungen sind sie dagegen unlöslich. Zur Herstellung einer Beschichtungslösung können eine oder mehrere dieser o-Naphthochinondiazide enthaltenden strahlungsempfindlichen Verbindungen in organischen Lösemitteln gelöst werden, und diese Lösung wird dann auf einen geeigneten Träger, z. B. aus Aluminium, Zink, Kupfer, Kunststoff, Papier usw., aufgetragen. Die Wahl des Trägers richtet sich nach dem vorgesehenen Verwendungszweck des Materials. Wenn ein mit einer dieser strahlungsempfindlichen Schichten beschichteter Träger beispielsweise durch eine Transparentvorlage belichtet wird, so werden die o-Naphthochinondiazide an den vom Licht getroffenen Stellen vermutlich zu Indencarbonsäuren zersetzt, die z. B. in alkalischer Lösung löslich sind. Durch die Lichteinwirkung kommt es also zu einem Unterschied in der Löslichkeit von belichteten und unbelichteten Stellen. Das Bild kann dann z. B. durch Behandeln mit einer geeigneten alkalischen Entwicklerlösung und Entfernen der löslich gewordenen Nichtbildstellen herausentwickelt werden.

Die in den obengenannten US-Patentschriften beschriebenen Verbindungen, von denen viele auch an anderer Stelle genannt sind, sind niedermolekulare Ester und Säureamide von Chinon- und o-Naphthochinondiaziden. Wird eine solche Verbindung, z. B. bei der Herstellung von Offsetdruckplatten, allein verwendet, so setzt sie sich in kristalliner Form ab. Dadurch wird die mechanische Festigkeit des Bildes vermindert, so daß hohe Druckauflagen nur schwer zu erzielen sind. Aus diesem Grund wird gewöhnlich ein geeignetes polymeres Harz im Gemisch mit der strahlungsempfindlichen Verbindung eingesetzt, um diese an der Kristallbildung zu hindern und jede Herabsetzung der mechanischen Festigkeit auszugleichen.

Für diesen Zweck verwendete geeignete polymere Harze sind z. B. alkalilösliche Harze, wie Schellack, Copolymere aus Styrol und Maleinsäureanhydrid, hydrophobe thermoplastische Polyurethane (wie in der US-PS 3 660 097 beschrieben) und insbesondere niedermolekulare Kondensationsprodukte aus Phenol und Formaldehyd, die sogenannten Novolake (US-PSen 3 148 983 und 3 188 210).

Beispiele für Phenol-Formaldehydharze sind einige der von der Hoechst AG hergestellten ® Alnovoltypen.

Zu den strahlungsempfindlichen Verbindungen zählen zum Beispiel :

2,2'-Bis(naphthochinon-(1,2)-diazid-(2)-sulfonyl-hydroxy-(5))-dinaphthyl-(1,1')-methan,

2,3-Bis(naphthochinon-(1,2)-diazid-2(2)-sulfonyl-hydroxy-(5))-dihydroxybenzophenon,

Naphthochinon-(1,2)-diazid-(2)-sulfonsäure-(5)-1,2,3-trihydroxybenzophenonester,

Naphthochinon-(1,2)-diazid-(4)-sulfonsäurechlorid,

Naphthochinon-(1,2)-diazid-(2)-sulfonylhydroxy-(4)-phenylcumen.

Das Harz wird in einer Menge von mindestens 0,1 Gew.-Teil auf 1 Gew.-Teil strahlungsempfindlicher Verbindung zugesetzt, vorzugsweise in einer Menge von 0,5 bis etwa 5 Gew.-Teilen auf 1 Gew.-Teil strahlungsempfindlicher Verbindung.

Die erfindungsgemäße Entwicklerlösung kann z. B. als wäßrige Lösung so formuliert werden, daß sie unmittelbar zum Entwickeln der Aufzeichnungsschichten verwendbar ist, oder sie kann zunächst als Konzentrat hergestellt werden, d. h. als wäßrige Lösung, in der die aktiven Bestandteile in einer Konzentration vorliegen, die höher ist als für einen Entwickler erforderlich. Das ist im Hinblick auf den Versand und die Lagerung vorteilhaft. Vor der Verwendung ist das Konzentrat dann mit Wasser bis auf die für den praktischen Gebrauch gewünschte Konzentration zu verdünnen.

Zur leichteren Entwicklung und zur Verbesserung der Schicht kann es auch wünschenswert sein, den Entwicklerlösungen weitere Bestandteile zuzusetzen. Solche Zusätze sind beispielsweise Lösemittel, Netzmittel oder Tenside, Metallreinigungsmittel usw.

Das Natriummetasilikat, vorzugsweise Natriummetasilikatpentahydrat oder Natriumsilikatnonahydrat, kann in einem Anteil von bis zu etwa 30 Gew.-%, vorzugsweise von 1 bis 20 Gew.-% und insbesondere von 3 bis 10 Gew.-% in der Entwicklerzusammensetzung enthalten sein. Der Gehalt an anorganischer Lithiumverbindung kann etwa 0,1 bis 10 Gew.-%, vorzugsweise 0,1 bis 3 Gew.-% und insbesondere 0,2 bis 1 Gew.-% betragen ; der übrige Bestandteil ist im wesentlichen Wasser. Die bevorzugte Menge jeder Lithiumverbindung schwankt innerhalb des angegebenen Bereichs, sie kann jedoch durch den Fachmann entsprechend der jeweils verwendeten strahlungsempfindlichen Schicht und der gewünschten Entwicklungsgeschwindigkeit leicht ermittelt werden.

Ohne sich auf irgendeine bestimmte Theorie festzulegen, nimmt man an, daß das an sich aggressive Natriummetasilikat durch die anorganische Lithiumverbindung abgeschwächt wird, so daß es einen schützenden Aluminiumsilikatfilm auf der Trägeroberfläche bildet, der eine wirksame Sperre gegen den weiteren Angriff darstellt. Mit dieser Erfindung soll die für die Entwicklung erforderliche Aggressivität des Natriummetasilikats beibehalten werden, ohne dabei insbesondere die Aluminium/Aluminiumoxidoberfläche anzugreifen.

In den folgenden Beispielen und Vergleichsbeispielen werden alle Entwicklerlösungen durch Entwickeln einer nach dem folgenden Verfahren hergestellten Platte ausgewertet :

Auf eine durch Bürsten naß aufgerauhte, anodisierte Aluminiumplatte wurde eine Lösung aus 6,5 Gew.-Teilen eines Novolakharzes, 2,2 Gew.-Teilen strahlungsempfindlicher Verbindung (1,2,3-Trihydroxybenzophenonester der Naphthochinon-(1,2)-diazid-(2)-sulfonsäure-(5)) in 100 Gew.-Teilen Ethylenglykolmonomethylether aufgeschleudert. Die Beschichtung auf der Platte hatte ein Gewicht von etwa 3 g/m². Die beschichtete Platte wurde dann getrocknet und unter einem positiven Original belichtet.

3

Anschließen wurde die belichtete Platte in der angegebenen wäßrig-alkalischen Entwicklerlösung entwickelt, und zwar einmal für 20 sec, um die Entwicklungsgeschwindigkeit zu bestimmen und danach für 7 min, um den Oxidangriff durch die Entwicklerlösung festzustellen.

Die Entwicklungsgeschwindigkeit einer gemäß dieser Erfindung geeigneten Entwicklerlösung reicht vorzugsweise aus, um nach einer Entwicklungszeit von 20 sec eine Ablesung von 4 Stufen auf dem Stauffer-Stufenkeil zu ergeben, während in dieser Zeit das Aluminium durch die Entwicklerlösung im wesentlichen nicht angegriffen wird.

Von einer für die Praxis akzeptablen Platte erwartet man, daß sie sich in etwa 20 sec entwickeln läßt. Mit dem 7-Minuten-Test sollen die Auswirkungen einer Überentwicklung untersucht werden. Wenn eine Platte nach 7 min keinen Oxidangriff aufweist, kann man daraus schließen, daß sie für den Einsatz unter normalen Praxisbedingungen zuverlässig ist.

Vergleichsbeispiele V1 bis V4

Entwicklerlösung mit Na-Metasilikat (Pentahydrat)

| Beispiel | Gew.-% | Anzahl der Stufen auf dem Stufenkeil | | Oxidangriff | |
|---|---|---|---|---|---|
| | | 20 sec | 7 min | 20 sec | 7 min |
| V1 | 3 | 2 | 3 | sehr gering | sehr gering |
| V2 | 5 | 2 | 7 | " | mäßig |
| V3 | 6 | 3 | *) | " | stark |
| V4 | 10 | 4 | *) | " | stark |

*) Anzahl der Stufen konnte wegen des starken Oxidangriffs nicht ermittelt werden

Vergleichsbeispiele V5 bis V8

Entwicklerlösung mit Na-Hydroxid

| Beispiel | Gew.-% | Anzahl der Stufen auf dem Stufenkeil | | Oxidangriff | |
|---|---|---|---|---|---|
| | | 20 sec | 7 min | 20 sec | 7 min |
| V5 | 0,5 | 2 | 5 | sehr gering | stark |
| V6 | 1,0 | 2 | *) | stark | stark |
| V7 | 2,0 | 4 | *) | stark | stark |
| V8 | 5,0 | *) | *) | stark | stark |

*) Vollständiges Ablösen der Beschichtung sowie starker Oxidangriff festgestellt

# 0 071 823

Vergleichsbeispiele V9 bis V12

Entwicklerlösung mit Lithiumhydroxid

| Beispiel | Gew.-% | Anzahl der Stufen auf dem Stufenkeil | | Oxidangriff | |
|---|---|---|---|---|---|
| | | 20 sec | 7 min | 20 sec | 7 min |
| V 9 | 0,5 | 2 | 2 | sehr ge-ring | stark |
| V10 | 1,0 | 2 | 8 | " | " |
| V11 | 2,0 | 5 | *) | " | " |
| V12 | 5,0 | *) | *) | " | " |

*) Anzahl der Stufen konnte wegen des starken Oxidangriffs nicht ermittelt werden.

Vergleichsbeispiele V13 bis V16

Entwicklerlösung mit Na-Metasilikat (Pentahydrat) und Na-Hydroxid

| Bei-spiel | Gew.-% | | Anzahl der Stufen auf dem Stufenkeil | | Oxidangriff | |
|---|---|---|---|---|---|---|
| | Na-Meta-silikat | Na-Hydroxid | 20 sec | 7 min | 20 sec | 7 min |
| V13 | 3 | 0,5 | 3 | *) | sehr gering | stark |
| V14 | 5 | 0,5 | 4 | *) | sehr gering | stark |
| V15 | 5 | 1,0 | 5 | *) | sehr gering | stark |
| V16 | 20 | 2,6 | ** ) | *) | sehr gering | sehr stark |

*) Vollständiges Ablösen der Beschichtung sowie starker Oxidangriff festgestellt
**) Beschichtung vollständig abgelöst.

Vergleichsbeispiele V17 bis V19

Entwicklerlösung mit Na-Metasilikat (Pentahydrat) und Lithiumbenzoat

| Bei-spiel | Gew.-% | | Anzahl der Stufen *) auf dem Stufenkeil | | Oxidangriff | |
|---|---|---|---|---|---|---|
| | Na-Meta-silikat | Lithium-benzoat | 20 sec | 7 min | 20 sec | 7 min |
| V17 | 3 | 0,5 | 2 | 3 | keiner | keiner |
| V18 | 3 | 10,0 | 2 | 7 | keiner | keiner |
| V19 | 5 | 10,0 | 3 | ** ) | keiner | keiner |

*) Entwicklungsgeschwindigkeit zu langsam für Verwendung unter normalen Praxisbedingungen
**) Beschichtung vollständig abgelöst.

5

# 0 071 823

Beispiel 1 bis 4

Entwicklerlösung mit Na-Metasilikat (Pentahydrat) und Lithiumhydroxid

| Bei-spiel | Gew.-% | | Anzahl der Stufen auf dem Stufenkeil | | Oxidangriff | |
|---|---|---|---|---|---|---|
| | Na-Meta-silikat | Lithium-hydroxid | 20 sec | 7 min | 20 sec | 7 min |
| 1 | 3 | 0,5 | 3 | 6 | keiner | keiner |
| 2 | 5 | 0,5 | 3 | *) | keiner | keiner |
| 3 | 5 | 1,0 | 4 | *) | keiner | keiner |
| 4 | 20 | 2,6 | *) | *) | keiner | keiner |

*) Beschichtung vollständig abgelöst, jedoch kein Oxidangriff.

Beispiele 5 bis 12 und Vergleichsbeispiele V20 und V21

Entwicklerlösung mit Na-Metasilikat (Pentahydrat) und anorganischen Lithiumsalzen

| Bei-spiel | Gew.-% | | Anzahl der Stufen auf dem Stufenkeil | | Oxidangriff | |
|---|---|---|---|---|---|---|
| | NaMS | an Lithiumsalzen | 20 sec | 7 min | 20 sec | 7 min |
| 5 | 5 | 1 LiBr oder LiCl | 3 | 5 | keiner | keiner |
| 6 | 5 | 1 $Li_2CO_3$ | 2 | 5 | " | " |
| 7 | 5 | 1 $LiNO_3$ | 2 | 5 | " | " |
| 8 | 5 | 1 $Li_2SO_4$ | 2 | 5 | " | " |
| V20 | 5 | ohne | 2 | 7 | " | mäßig |
| 9 | 10 | 1 LiBr oder LiCl | 4 | *) | " | keiner |
| 10 | 10 | 1 $Li_2CO_3$ | 4 | *) | " | " |
| 11 | 10 | 1 $LiNO_3$ | 5 | *) | " | " |
| 12 | 10 | 1 $Li_2SO_4$ | 5 | *) | " | " |
| V21 | 10 | ohne | 4 | **) | " | stark |

*) Beschichtung vollständig abgelöst
**) Neben vollständiger Ablösung der Beschichtung starker Oxidangriff und dicke, kreideartige Ablagerung festgestellt

Jedesmal, wenn in den angeführten Beispielen ein « sehr geringer » Oxidangriff angegeben ist, ist dieser so schwach, daß er mit dem bloßen Auge nicht zu erkennen ist. Die Ansammlung von Präzipitat aus diesem Reaktionsprodukt führt jedoch immer noch zu den erwähnten Nachteilen.

**Patentansprüche**

1. Wäßrig-alkalische Entwicklerlösung für belichtete, positiv-arbeitende strahlungsempfindliche Reproduktionsschichten mit einem Gehalt an Lithiumverbindungen, dadurch gekennzeichnet, daß sie 0,1

6

bis 10 Gew.-% mindestens einer anorganischen Lithiumverbindung aus der Gruppe Lithiumhydroxid, -chlorid, -bromid, -nitrat, -carbonat und -sulfat und 1 bis 20 Gew.-% Natriummetasilikat enthält.

2. Entwicklerlösung nach Anspruch 1, dadurch gekennzeichnet, daß sie Natriummetasilikat in einem Anteil von 3 bis 10 Gew.-% enthält.

3. Entwicklerlösung nach Anspruch 1, dadurch gekennzeichnet, daß sie die anorganische(n) Lithiumverbindung(en) in einem Anteil von 0,1 bis 3 Gew-% enthält.

4. Entwicklerlösung nach Anspruch 1, dadurch gekennzeichnet, daß sie die anorganische(n) Lithiumverbindung(en) in einem Anteil von 0,2 bis 1 Gew.-% enthält.

5. Verfahren zum Entwickeln von belichteten, positiv-arbeitenden strahlungsempfindlichen Reproduktionsschichten mit einer wäßrig-alkalischen Entwicklerlösung eines Gehalts an Lithiumverbindungen, dadurch gekennzeichnet, daß eine Lösung mit einem Gehalt von 0,1 bis 10 Gew.-% an mindestens einer anorganischen Lithiumverbindung aus der Gruppe Lithiumhydroxid, -chlorid, -bromid, -nitrat, -carbonat und -sulfat und von 1 bis 20 Gew.-% an Natriummetasilikat eingesetzt wird.

## Claims

1. Aqueous-alkaline developer solution for exposed, positive-working radiation-sensitive reproduction layers, which comprises lithium compounds, characterized in that it contains from 0.1 to 10 % by weight of at least one inorganic lithium compound selected from the group consisting of lithium hydroxide, chloride, bromide, nitrate, carbonate, and sulfate and from 1 to 20 % by weight of sodium metasilicate.

2. A developer solution as claimed in claim 1, which contains sodium metasilicate in a proportion from 3 to 10 % by weight.

3. A developer solution as claimed in claim 1, which contains the inorganic lithium compound(s) in a proportion from 0.1 to 3 % by weight.

4. A developer solution as claimed in claim 1, which contains the inorganic lithium compound(s) in a proportion from 0.2 to 1 % by weight.

5. Process for developing exposed, positive-working radiation-sensitive reproduction layers using an aqueous-alkaline developer solution which comprises lithium compounds, characterized in that a solution is employed which contains from 0.1 to 10 % by weight of at least one inorganic lithium compound selected from the group consisting of lithium hydroxide, chloride, bromide, nitrate, carbonate, and sulfate and from 1 to 20 % by weight of sodium metasilicate.

## Revendications

1. Révélateur alcalino-aqueux pour couches de reproduction photosensibles impressionnées fournissant des positifs, contenant des composés du lithium, caractérisé en ce qu'il contient 0,1 à 10 % en poids d'au moins un composé minéral du lithium provenant du groupe hydroxyde de lithium, chlorure de lithium, bromure de lithium, nitrate de lithium, carbonate de lithium et sulfate de lithium, ainsi que 1 à 20 % en poids de métasilicate de sodium.

2. Révélateur selon la revendication 1, caractérisé en ce qu'il contient du métasilicate de sodium dans une proportion de 3 à 10 % en poids.

3. Révélateur selon la revendication 1, caractérisé en ce qu'il contient le(s) composé(s) minéral (minéraux) du lithium dans une proportion de 0,1 à 3 % en poids.

4. Révélateur selon la revendication 1, caractérisé en ce qu'il contient le(s) composé(s) minéral (minéraux) du lithium dans une proportion de 0,2 à 1 % en poids.

5. Procédé pour le développement, à l'aide d'un révélateur alcalino-aqueux contenant des composés du lithium, de couches de reproduction photosensibles impressionnées fournissant des positifs, caractérisé en ce que l'on utilise une solution contenant 0,1 à 10 % en poids d'au moins un composé minéral du lithium provenant du groupe hydroxyde de lithium, chlorure de lithium, bromure de lithium, nitrate de lithium, carbonate de lithium et sulfate de lithium, ainsi que 1 à 20 % en poids de métasilicate de sodium.